# EUROPÄISCHE PATENTANMELDUNG

(11) **EP 4 404 705 A1**
(43) Veröffentlichungstag der Anmeldung: **24.07.2024**
(21) Anmeldenummer: 23211678.0
(22) Anmeldetag: 23.11.2023
(51) Int. Cl.: H05K 7/20

(54) **VERFAHREN ZUM KLIMATISIEREN VON VERLUST- ODER ABWÄRMEERZEUGENDEN KOMPONENTEN, INSBESONDERE KOMPONENTEN EINES RECHENZENTRUMS**

(30) Priorität: 17.01.2023 DE 102023101055; 06.04.2023 DE 102023108888
(71) Anmelder: MEGWARE Computer Vertrieb und Service GmbH, 09247 Chemnitz-Röhrsdorf (DE)
(72) Erfinder: Auweter, Axel, 04416 Markkleeberg (DE); Trepte, Wolfgang, 01665 Diera-Zehren (DE)
(74) Vertreter: Meissner Bolte Partnerschaft mbB

(57) **Zusammenfassung**

Verfahren zum Klimatisieren von verlust- oder abwärmeerzeugenden Komponenten (9), insbesondere Komponenten (9) eines Rechenzentrums, wobei die Gesamtheit der Komponenten (9) in einer Umhausung, insbesondere einem Container (20) befindlich ist, wobei die Komponenten (9) einerseits unmittelbar an einen ersten Kühlwasserkreislauf gekoppelt und andererseits mittelbar über einen zweiten Kühlwasserkreislauf mit Luft-Wärmetauscher angebunden sind, wobei zur Kälteerzeugung für den zweiten Kühlwasserkreislauf eine Kaskade von parallelverschalteten, einzeln oder in Gruppen aktivierbaren Wärmepumpen (3) vorgesehen ist, wobei auf der Kondensatorseite (14) der jeweiligen Wärmepumpe (3) mittels Dreiwegeventil (10) eine Umschaltung von einem Kühlbetrieb zur Kälteerzeugung auf einen Heizbetrieb eines angeschlossenen Heizkreislaufes (1) realisierbar ist.

## Beschreibung

Die Erfindung betrifft ein Verfahren zum Klimatisieren von verlust- oder abwärmeerzeugenden Komponenten, insbesondere Komponenten eines Rechenzentrums, wobei die Gesamtheit der Komponenten in einer Umhausung, insbesondere einem Container befindlich ist, wobei die Komponenten einerseits unmittelbar an einen ersten Kühlwasserkreislauf gekoppelt und andererseits mittelbar über einen zweiten Kühlwasserkreislauf mit Luft-Wärmetauscher angebunden sind, gemäß Anspruch 1.

Aus der DE 10 2019 127 752 A1 ist ein Rechenzentrum vorbekannt, das eine in einem Raum angeordnete Rechenanlage enthält, wobei die Rechenanlage mehrere Kühlkörper und mehrere Prozessoren aufweist, von denen jeder Prozessor mit einem Kühlkörper der mehreren Kühlkörper thermisch gekoppelt ist. Weiterhin ist dort eine Wärmepumpe vorgesehen und ein im Raum angeordneter Gas-Fl üssigkeits-Wärmetauscher.

Auch ist ein Heißflüssigkeits-Kreislauf vorhanden, welcher die mehreren Kühlkörper mit dem Gas-Flüssigkeits-Wärmetauscher koppelt, wobei der Heißflüssigkeits-Kreislauf an einer Wand des Raumes mit den Rechnern einen Heißflüssigkeits-Anschluss besitzt. Ebenso ist ein Kaltflüssigkeits-Kreislauf vorhanden, welcher die Wärmepumpe mit dem Gas-Flüssigkeits-Wärmetauscher koppelt. Die Wärmepumpe ist so eingerichtet, dem Kaltflüssigkeits-Kreislauf thermische Energie zu entziehen und diese dem Heißflüssigkeits-Kreislauf zuzuführen.

Das o.g. Konzept soll eine große Menge von Abwärme einer hohen Anzahl von Prozessoren abführen, um hierdurch das Rechenzentrum ausreichend kühlen zu können.

Mit der vorgestellten Lösung soll ein ganzjähriges Betreiben eines Rechenzentrums mit ausreichender Kühlung auch dann möglich sein, wenn keine natürlichen Wärmesenken vorhanden sind, was Jahreszeitenabhängig ist.

Die vorgestellte Kühl-Infrastruktur mit zwei Wärmekreisläufen, insbesondere Wasserkreisläufen, die ein unterschiedliches Temperaturniveau aufweisen, ist mittels einer Wärmepumpe gekoppelt. Im Betrieb wird der Luft innerhalb des Raumes mit den Rechnern unter Nutzung des niedrigen Temperaturniveaus Wärme entzogen. Die Wärme wird mit Hilfe der Wärmepumpe auf ein höheres Temperaturniveau angehoben und in das höhere Temperaturniveau eingespeist, mit dessen Hilfe ein Abtransport der Wärme möglich ist. Die Energie mit höherer Temperatur soll einer wirtschaftlichen Nutzung zuführbar sein. Der Raum zur Aufnahme einer Vielzahl von Rechnern kann in einer Ausgestaltung gemäß der Lehre nach DE 10 2019 127 752 A1 als Container eingerichtet sein.

Die EP 3 287 717 A1 offenbart ein Verfahren zum Betreiben einer Kaskadenschaltung mehrerer kühl- und/oder wärmetechnischer Anlagen.

Die Kaskadenschaltung wird dann aktiviert, wenn die mittels eines Temperatursensors gemessene Temperatur einen Sollwert wärmetechnischer Anlagen unterschreitet oder bei kältetechnischen Anlagen überschreitet. Im Nachgang wird eine Zeiterfassung gestartet und es besteht die Möglichkeit, eines modulierenden Betriebes, wobei zunächst alle zugeschalteten Anlagen erst bis zu einer vorgegebenen Teillast betrieben werden und nach Teillastbetrieb eine Laststeigerung vorgenommen wird.

Zum Stand der Technik sei noch auf das Wärmerückgewinnungssystem zur Rückgewinnung von Abwärme aus industriellen Flüssigkeiten mit niedrigen Temperaturen gemäß DE 20 2019 101 219 U1 verwiesen.

Gemäß dem geschilderten Stand der Technik verbleibt zusammenfassend festzustellen, dass die Kühlung containerbasierter Rechenzentren mit einer Vielzahl von Prozessoren bzw. Rechnerknoten bekannt ist. Hierbei kommt eine sogenannte Kaltwasserkühlung, auch kombiniert mit einer Warmwasserkühlung zum Einsatz.

Bei der Kaltwasserkühlung wird kaltes Wasser über einen Wärmetauscher geführt. Dieser Wärmetauscher sitzt beispielsweise an einer der Seitenflächen, insbesondere der Rückseite von Rechnerschränken. Die von den Rechnern erwärmte Luft wird von den Wärmetauschern unmittelbar vor oder bei dem Austritt aus dem Rechnerschrank gekühlt, so dass sich der umgebende Raum, in dem sich die Rechner befinden, zum Beispiel ein Container, trotz im Betrieb befindlicher Rechner nicht übermäßig erwärmt.

Bei der Warmwasserkühlung wird Kühlwasser direkt zu besonders leistungsstarken Komponenten der Rechner geführt und die dort entstehende Wärme ohne Luft als Wärmeübertrager abgeführt. Das Kühlwasser durchströmt hier speziell ausgebildete Kühlkörper, die optimal wärmeleitend mit integrierten Schaltkreisen, insbesondere Prozessoren verbunden sind. Die Effizienz dieser Art Kühlung erlaubt einem Betrieb auch mit relativ warmen Wasser, so dass keine Prozesskälte erforderlich ist.

Die anfallende thermische Energie kann über ein Rückkühlwerk ohne Kältemaschine unmittelbar an die Umgebungsluft abgegeben werden.

Aus dem Vorgenannten ist es Aufgabe der Erfindung, ein weiterentwickeltes Verfahren zum Klimatisieren von verlust- oder abwärmeerzeugenden Komponenten, insbesondere Komponenten eines Rechenzentrums anzugeben, wobei die thermische Energie, welche in eine an sich bekannte Kaltwasserkühlung eingetragen wird, bedarfsweise zur Beheizung angrenzender Räumlichkeiten genutzt werden kann. Zusätzlich soll die Möglichkeit bestehen, bei entsprechendem Bedarf auch thermische Energie aus dem Kreislauf einer Warmwasserkühlung nutzen zu können.

Weiterhin ist sicherzustellen, dass die angeschlossene, zum Beispiel in einem separaten Container befindliche, Raumheizung auch dann gewährleistet ist, wenn die Rechentechnik ausfällt und insofern keine Abwärme zur Verfügung steht.

Die Lösung der Aufgabe der Erfindung erfolgt durch die Lehre gemäß dem Verfahren nach Patentanspruch 1 sowie der Anwendung nach Patentanspruch 12, wobei die Unteransprüche mindestens zweckmäßige Ausgestaltungen und Weiterbildungen darstellen.

Die Erfindung geht demnach von einem Verfahren zum Klimatisieren von verlust- oder abwärmeerzeugenden Komponenten, insbesondere Komponenten eines Rechenzentrums aus, wobei die Gesamtheit der Komponenten in einer Umhausung, insbesondere einem Container befindlich ist.

Die Komponenten sind einerseits unmittelbar an einen ersten Kühlwasserkreislauf gekoppelt und andererseits mittelbar über einen zweiten Kühlwasserkreislauf mit Luft-Wärmetauscher angebunden, und zwar im Sinne der eingangs geschilderten Kaltwasser- und Warmwasserkühlungsmethodik.

Erfindungsgemäß ist zur Kälteerzeugung für den zweiten Kühlwasserkreislauf eine Kaskade von parallelverschalteten, einzeln oder in Gruppen aktivierbaren Wärmepumpen vorgesehen. Dabei kann es sich um bis zu acht oder mehr kaskadierten Wärmepumpen handeln.

Auf der Kondensatorseite der jeweiligen Wärmepumpe ist mittels eines Dreiwegeventils eine Umschaltung von einem Kühlbetrieb zur Kälteerzeugung auf einen Heizbetrieb eines angeschlossenen oder anschließbaren Heizkreislaufes realisierbar.

Zur Erhöhung des Wirkungsgrades im Kühlbetrieb ist auf der Kondensatorseite der jeweiligen Wärmepumpe die Kondensationstemperatur niedriger gewählt als im Heizbetrieb.

Kondensatorseitig ist der jeweiligen Wärmepumpe ein steuerbares Drosselventil nachgeordnet, so dass der Volumenstrom vorgebbar ist.

In dem gebäudeseitigen Heizkreislauf wird ein Strömungssensor angeordnet. Hierdurch kann bei Heizbedarf dieser detektiert sowie der Betrieb einer Pumpe ausgelöst werden, wodurch das Heizungswasser im Kreislauf zwischen einem Wärmeübertrager und der oder den jeweiligen aktiven Wärmepumpen gefördert wird.

Erfindungsgemäß sollen die Wärmepumpen abwechselnd bzw. rotierend betrieben werden, so dass eine möglichst gleichmäßige Betriebsstundenzahl erreicht werden kann.

Für die Ansteuerung der in den Heizkreis einspeisenden Wärmepumpen im Sommer- oder Übergangsbetrieb werden bevorzugt diejenigen ausgewählt, welche bereits aufgrund der Komponentenkühlung im Betrieb waren bzw. sind.

Für einen Notklimatisierungsbetrieb bei Ausfall der abwärmeerzeugenden Komponenten ist mindestens eine der Wärmepumpen in einen Betrieb als Luft-Wasser-Wärmepumpe umschaltbar.

Die erwähnten Wärmepumpen stehen mit einem außenseitig der Umhausung bzw. den im erwähnten Container befindlichen Rückkühler in Verbindung.

Zur Übertragung von Wärmeenergie aus dem zweiten Kühlwasserkreislauf mit Luft-Wärmetauscher in den ersten Kühlwasserkreislauf ist gemäß einer Ausgestaltung der Erfindung ein Bypass ausgebildet, der entsprechend aktiviert werden kann. Bevorzugt wird der Bypass über ein steuerbares Dreiwegeventil realisiert.

Ein weiteres Dreiwegeventil stellt eine unmittelbare Verbindung des ersten oder zweiten Kühlwasserkreislaufes mit dem Rückkühler zum sogenannten Freikühlbetrieb her.

Mittels des Dreiwegeventils ist darüber hinaus eine Abkopplung der Komponenten möglich und über das oben erwähnte weitere Dreiwegeventil eine Verbindung zum Rückkühler herstellbar, um Wärmeenergie aus der Umgebung zu gewinnen.

Die erfindungsgemäße Anwendung besteht in der Nutzung des Verfahrens wie beschrieben zur Kühlung und Klimatisierung eines Container-basierten Rechenzentrums und angeschlossener, zu beheizender Räumlichkeit für Administrations- und Betriebspersonal, wobei die Kühlung der Rechner über kaltwassergespeiste Wärmetauscher an oder in den Rechnergehäusen zur Kühlung erwärmter Luft sowie mittelbarer Warmwasserkühlung von leistungsstarken Rechnerkomponenten erfolgt.

Die Kühlung der Rechner bzw. der Rechnerknoten erfolgt so durch prinzipiell zwei getrennte Wasserkreisläufe, wobei ein Wasserkreislauf die besonders abwärmeintensiven Komponenten direkt kühlt und der weitere, zweite Wasserkreislauf eine Kühlung indirekt über Luft-Wasser-Wärmeübertrager sicherstellt. Die diesbezüglich gekühlten Komponenten können zum Beispiel sonstige Leiterplatten, Netzteile oder dergleichen umfassen.

Über die in einer Kaskade aufgestellten Wärmepumpen kann der angeschlossene Wasserkreislauf zur Heizung aber auch zur Kühlung umgesetzt werden. Die entsprechende Schaltung zwischen Kühlbetrieb und Heizbetrieb erfolgt über vorgesehene Dreiwegeventile, wobei zur Erhöhung des Wirkungsgrades im Kühlbetrieb auf der Kondensatorseite der Wärmepumpen die Kondensationstemperatur niedriger gewählt ist als im Heizbetrieb. Diesbezüglich kommen Drosselventile zum Einsatz, welche in der Lage sind, den Volumenstrom zur Kühlung des entsprechenden Kondensators so weit zu drosseln, bis die gewünschte Sollwerttemperatur für den Heizbetrieb erreicht wurde.

Wenn die Wassertemperaturen oberhalb der über eine von einem Temperatursensor gemessenen Außentemperatur liegen und kein Heizungsbedarf besteht, kann eine Kühlung direkt über den Freikühler bei entsprechender Schaltung mittels Dreiwegeventil erfolgen.

Bei Kühlwassertemperaturen unterhalb der Außentemperatur erfolgt eine stufenweise Zuschaltung der Wärmepumpen in Abhängigkeit von der jeweils benötigten Kühlleistung.

Grundsätzlich können gleichzeitig Wärmepumpen der Kaskade im Heizbetrieb hingegen andere Wärmepumpen der Kaskade im Kühlbetrieb geschalten werden.

Die Erfindung soll nachstehend anhand eines Ausführungsbeispieles und von Figuren näher erläutert werden.

### Ergänzung:

In den Figuren werden für dieselben Teile oder Komponenten die gleichen Bezugszeichen verwenden. Im Übrigen verwenden die Figuren fachübliche Darstellungen und Symbole von Hydraulikelementen. Mit dem Großbuchstaben "K" wird die Kaltwasserführung und mit dem Großbuchstaben "W" die Warmwasserführung bezeichnet.

Es zeigen:

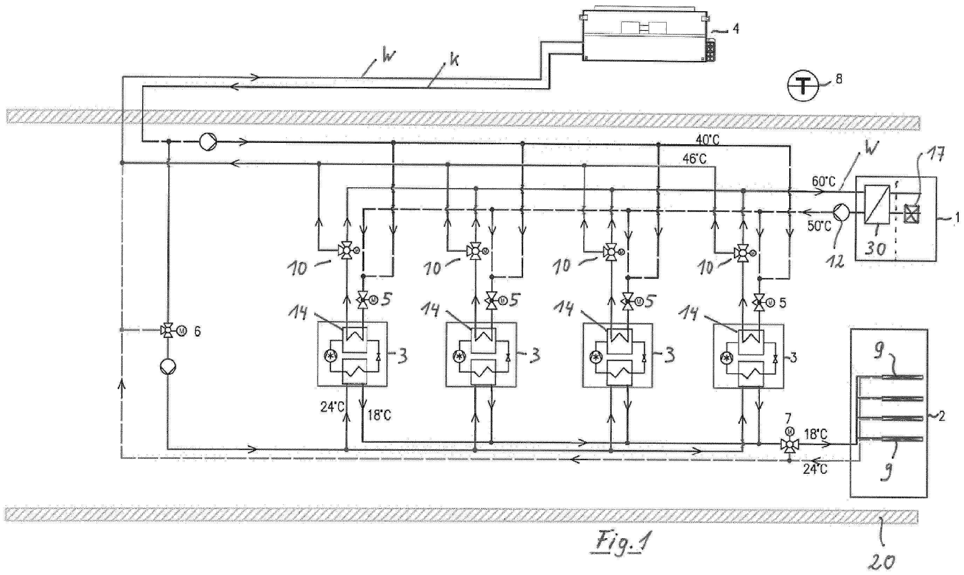

- Fig. 1: ein vereinfachtes hydraulisches Schema einer Anordnung mit deren Hilfe das erfindungsgemäße Verfahren betrieben werden kann;
- Fig. 2: eine Darstellung ähnlich derjenigen nach Fig. 1, jedoch im Zustand aktivierter Wärmepumpen zur Kühlung eines Rechenzentrums im Sommerbetrieb;
- Fig. 3: eine Darstellung eines vereinfachten hydraulischen Schemas im Zustand eines Mischbetriebes zum gleichzeitigen Heizen und Kühlen, wobei eine der Wärmepumpen inaktiv ist;
- Fig. 4: eine Darstellung eines vereinfachten hydraulischen Schemas, wobei die Wärmepumpen zur Beheizung einer angeschlossenen Räumlichkeit sich im Winterbetrieb befinden; und
- Fig. 5: eine vereinfachte schematische Darstellung eines Notbetriebes bei Ausfall oder bei Wartungsarbeiten der Komponenten des Rechenzentrums mit Wärmerückgewinnung aus der Luft zur Sicherstellung der Beheizung einer angeschlossenen Räumlichkeit.

In den Figuren ist mit dem Bezugszeichen 20 ein Container symbolisiert, der ein Rechnersystem mit entsprechender Serverkühlung 2 aufnimmt. Ein Temperatursensor 8 ist außerhalb des Containers befindlich, um die Umgebungstemperatur bestimmen zu können.

Beispielsweise auf der Oberseite des Containers 20 befindet sich ein Rückkühler 4, der hydraulisch mit dem übrigen System verschalten ist.

Die Anordnung zur Durchführung des Verfahrens umfasst darüber hinaus mehrere, im gezeigten Beispiel vier, kaskadierte, parallelschaltbare Wärmepumpen 3 mit entsprechender Kondensatorseite 14.

Drosselventile 5 dienen der Erhöhung der Warmwassertemperatur im Heizbetrieb.

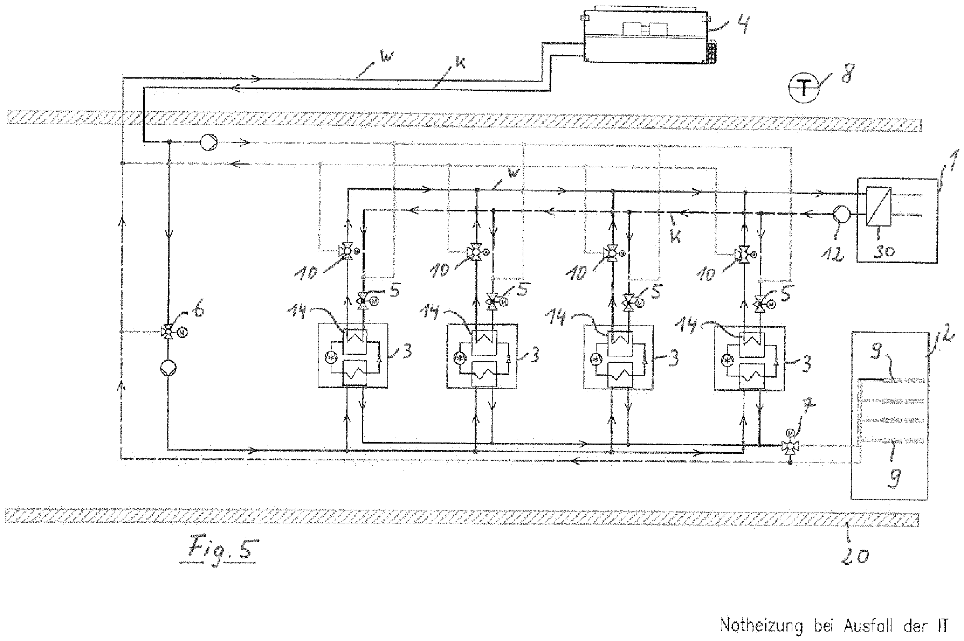

Ein Dreiwegeventil 6 dient der Umschaltung zum Freikühlbetrieb über den Rückkühler 4. Ein weiteres Dreiwegeventil (7) dient der Umschaltung in den Notbetrieb bei fehlender wärmeenergieerzeugender Last (siehe auch Figur 5).

Die zu kühlenden Komponenten des Rechenzentrums sind mit dem Bezugszeichen 9 symbolisiert.

Zur Vereinfachung sind ein erster Kühlwasserkreislauf mit unmittelbarer Kopplung an die Komponenten 9 und ein zweiter Kühlwasserkreislauf mit Luft-Wärmetauscher zur mittelbaren Ankopplung nicht getrennt dargestellt.

Zur eigentlichen Kälteerzeugung ist, wie in den Figuren ersichtlich, eine Kaskade von parallelverschalteten, einzeln oder in Gruppen aktivierbaren Wärmepumpen 3 vorgesehen.

Auf der Kondensatorseite 14 der jeweiligen Wärmepumpe 3 ist mittels eines jeweiligen Dreiwegeventils 10 eine Umschaltung von einem Kühlbetrieb zur Kälteerzeugung auf einen Heizbetrieb zur Raumheizung eines angeschlossenes Raumes 1 realisierbar. Kondensatorseitig sind den jeweiligen Wärmepumpen 3 steuerbare Drosselventile 5 nachgeordnet, so dass der Volumenstrom zur Kondensatorkühlung vorgebbar ist.

In einem gebäudeseitigen Heizkreislauf (Raumheizung 1) ist ein Strömungssensor 17 befindlich, um einen Heizbedarf zu detektieren. Bei detektiertem Heizbedarf wird der Betrieb einer Pumpe 12 ausgelöst, wodurch das Heizungswasser im Kreislauf zwischen einem Wärmeübertrager 30 und der oder den jeweils aktivierten Wärmepumpen 3 gefördert wird.

Mit Hilfe des Dreiwegeventils 7 ist eine Abkopplung von den Komponenten 9 möglich und dann mittels des Dreiwegeventils 6 eine Verbindung zum Rückkühler 4 herstellbar, um Wärmeenergie aus der Umgebung zu gewinnen.

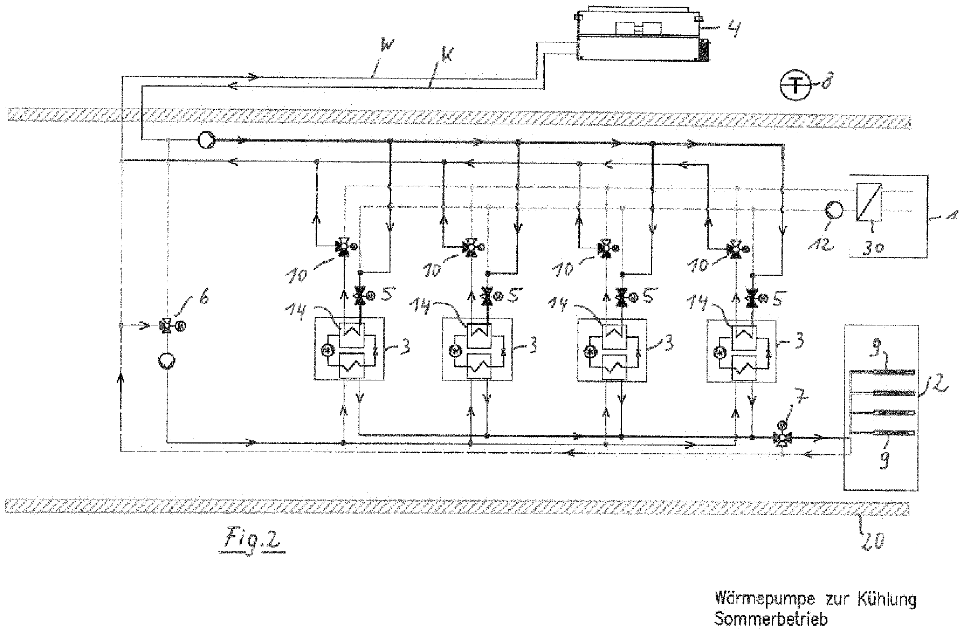

Wie anhand des hydraulischen Schemas nach Figur 2 nachvollziehbar ist, erfolgt eine Kühlung im Sommerbetrieb mit Hilfe der Wärmepumpen 3.

Ein "Sommerbetrieb" ist dann gegeben, wenn die Temperaturen im Kaltwasserkreis unterhalb der erreichbaren Freikühltemperatur liegen.

In Abhängigkeit von der benötigten Kühlleistung werden jeweils zusätzliche Wärmepumpen aktiviert. Mit dem Einschalt- oder Ausschaltvorgang einer entsprechenden Wärmepumpe 3 wird auch das zugehörige Zweiwegeventil 5 vollständig geöffnet oder geschlossen.

Die Wärmepumpen 3 werden nach Möglichkeit rotierend betrieben, um einen gleichmäßigen Verschleiß gegen eine gleichmäßige Betriebsstundenanzahl zu gewährleisten.

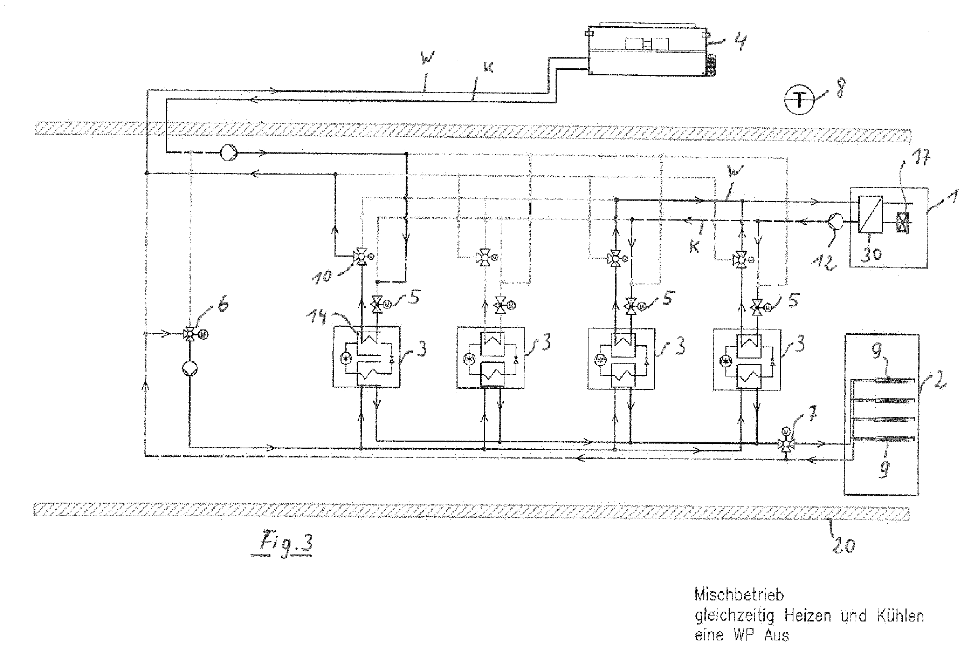

Da es auch im Sommer zu einer Heizungsanforderung kommen kann, zum Beispiel bei einer notwendigen Brauchwassererwärmung, besteht die Möglichkeit, auch im Sommerbetrieb Wärme auszukoppeln, wie dies mit der Figur 3 dargestellt ist.

Das Detektieren einer Heizungsanforderung erfolgt über einen Strömungssensor 17, der in die gebäudeseitige Heizungsanlage integriert ist. Wenn über den Sensor 17 eine Strömung erkannt wurde, wird die Pumpe 12 zugeschalten, welche das Heizungswasser im Kreislauf zwischen Wärmeübertrager und den zur Kühlung des Rechenzentrums aktiven Wärmepumpen 3 fördert.

Nachdem bei einer Heizungsanforderung die Pumpe 12 zugeschalten wurde, wird unter den aktiven Wärmepumpen 3 eine Auswahl vorgenommen und über das zugehörige Zweiwegeventil 5 per PID-Regler der Volumenstrom so weit eingeschränkt, dass eine entsprechende Austrittstemperatur aus der Wärmepumpe 3 von zum Beispiel 60° (hier handelt es sich um einen einstellbaren Sollwert) erreicht und gehalten wird.

Sobald die Austrittstemperatur der gewählten Wärmepumpe 3 den Sollwert erreicht hat, wird über das zugehörige Dreiwegeventil wiederum per PID-Regler so viel erwärmtes Wasser in Richtung Wärmeübertrager 30 geleitet, dass die Austrittstemperatur aus dem Wärmeübertrager 30 auf einen einstellbaren Sollwert von z. B. ca. 55° eingehalten wird.

Bei Sinken der Wärmeabnahme der Gebäudeheizung wird über die Regelung dafür gesorgt, dass überschüssige Abwärme zum Rückkühler 4 gelangt, so dass es nicht zu möglichen Hochdruckstörungen an der entsprechenden Wärmepumpe 3 kommt.

Wenn der Bedarf an Heizleistung steigt, wird aus den aktiven Wärmepumpen 3 eine weitere ausgewählt, deren Abwärme zum Wärmeübertrager 30 zu führen ist.

Wird über den Strömungssensor 17 keine Strömung detektiert, werden alle entsprechenden Ventile geschlossen und auf den Kühlbetrieb umgeschalten.

Bei der Auswahl der Wärmepumpen 3, welche in den Heizkreis mit Wärmetauscher 30 einspeisen, ist es vorteilhaft, nur diejenigen Wärmepumpen 3 auszuwählen, welche bereits aufgrund der Kühlungsanforderungen der Komponenten 9 im Betrieb sind.

Wird aufgrund eines sinkenden Kältebedarfes der Komponenten 9 eine Wärmepumpe 3 ausgeschalten, so sollte die Wärmepumpe 3, welche nicht an der Heizungseinspeisung beteiligt ist, in einen Aus-Zustand überführt werden.

Fällt der Kältebedarf weiter, können auch solche Wärmepumpen 3, die an der Heizungseinspeisung beteiligt sind, abgeschalten werden. Diejenige Wärmepumpe 3, welche für die leistungsabhängige Heizungsregelung verantwortlich ist, soll bei sinkendem Kältebedarf als letzte der Pumpen 3 ausgeschalten werden.

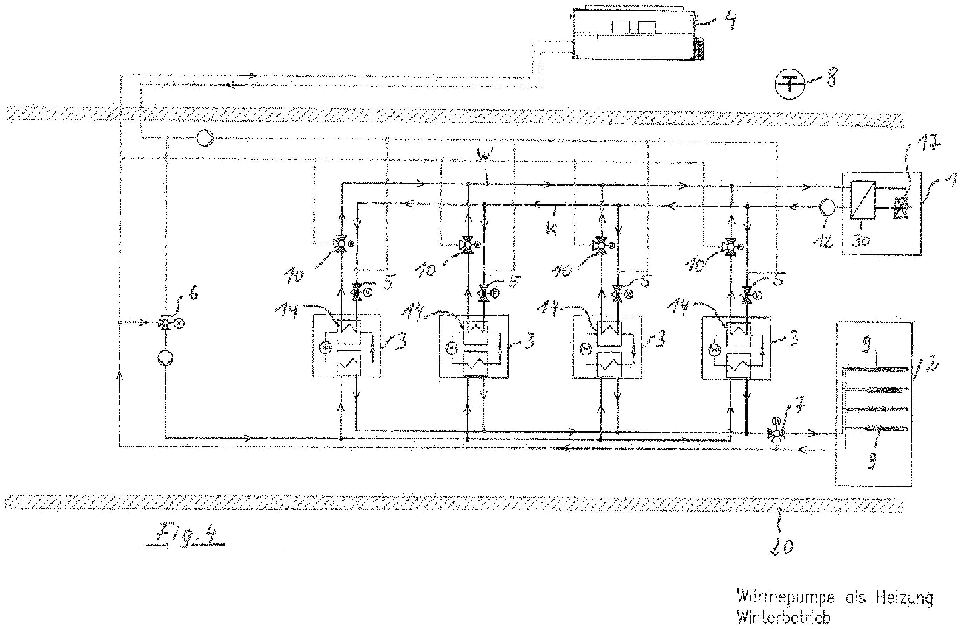

Die Betriebsart "Winterbetrieb" wie mit dem Schema nach Figur 4 dargestellt, ist für die Übergangs- und Winterzeit vorgesehen und dann zu aktivieren, wenn der Rückkühler 4 aufgrund geringerer Außentemperatur die Kühlung des Kaltwasserkreises vollständig oder teilweise übernehmen kann.

In der Übergangszeit erfolgt ein gemischter Kühlbetrieb, das heißt es erfolgt eine Vorkühlung des Kaltwassers über den Rückkühler der Wärmepumpen. Anschließend wird das Kühlwasser über die Verdampferseite der Wärmepumpen 3 auf die Zieltemperatur der Luft-Wasserwärmetauscher gekühlt.

In der Betriebsart "Winter" besteht die Möglichkeit, das Einschalten der Wärmepumpen 3 infolge einer Heizungsanforderung zu vollziehen.

In diesem Fall wird die Wärmeenergie auf der Kondensatorseite 14 der Wärmepumpen 3 zur Raumheizung genutzt. Die entsprechende Energie wird je nach Heizungsbedarf zum Wärmeübertrager 30 geführt.

Mit der gemäß dem Schema nach Figur 5 dargestellten Variante besteht die Möglichkeit einer Notheizung dann, wenn die Rechentechnik, das heißt die Komponenten 9, vollständig abgeschalten oder zu Wartungszwecken teilweise außer Betrieb genommen wurden.

Hierdurch besteht die Möglichkeit, Wärmeleistung unabhängig von der Abwärme seitens der Komponenten bereitzustellen. Hierdurch ist die Möglichkeit geschaffen, eine angeschlossene Räumlichkeit oder aber auch den Container zur Aufnahme der Rechentechnik vor Frostschäden abzusichern.

In dem in Figur 5 gezeigten Modus arbeiten die Wärmepumpen 3 als Luft-Wasserwärmepumpen und entnehmen die Wärmeenergie der Außenluft.

Ergänzend besteht die Möglichkeit, dass zur Erkennung von Leckagen in der hydraulischen Rohranordnung Drucksensoren eingesetzt werden. Bei Druckabfall erfolgt eine Alarmanzeige. Hierdurch kann auch ein schädlicher Trockenlauf der eingesetzten Pumpen verhindert werden. Bevorzugt kommen differenzdruckgesteuerte Pumpen zum Einsatz.

Mit den Lösungen gemäß dem geschilderten Ausführungsbeispiel ist zum einen der jeweilige Kältebedarf des Rechnersystems, aber auch der Heizbedarf einer angekoppelten Räumlichkeit über die eingesetzte Wärmepumpenkaskade steuerbar. Grundsätzlich kann das von der Prozessor- oder Chipkühlung erwärmte Wasser zur Verhinderung des Auskühlens des Gesamtsystems und insbesondere einer angeschlossenen, zu beheizenden Räumlichkeit genutzt werden.

## Patentansprüche

1. Verfahren zum Klimatisieren von verlust- oder abwärmeerzeugenden Komponenten (9), insbesondere Komponenten (9) eines Rechenzentrums, wobei die Gesamtheit der Komponenten (9) in einer Umhausung, insbesondere einem Container (20) befindlich ist, wobei die Komponenten (9) einerseits unmittelbar an einen ersten Kühlwasserkreislauf gekoppelt und andererseits mittelbar über einen zweiten Kühlwasserkreislauf mit Luft-Wärmetauscher angebunden sind,
**dadurch gekennzeichnet, dass**
zur Kälteerzeugung für den zweiten Kühlwasserkreislauf eine Kaskade von parallelverschalteten, einzeln oder in Gruppen aktivierbaren Wärmepumpen (3) vorgesehen ist, wobei auf der Kondensatorseite (14) der jeweiligen Wärmepumpe (3) mittels Dreiwegeventil (10) eine Umschaltung von einem Kühlbetrieb zur Kälteerzeugung auf einen Heizbetrieb eines angeschlossenen Heizkreislaufes (1) realisierbar ist.

2. Verfahren nach Anspruch 1,
**dadurch gekennzeichnet, dass**
zur Wirkungsgraderhöhung im Kühlbetrieb auf der Kondensatorseite (14) der jeweiligen Wärmepumpe (3) die Kondensationstemperatur niedriger gewählt ist als im Heizbetrieb.

3. Verfahren nach Anspruch 2,
**dadurch gekennzeichnet, dass**
kondensatorseitig der jeweiligen Wärmepumpe (3) ein steuerbares Drosselventil (5) nachgeordnet ist, so dass der Volumenstrom zur Kondensatorkühlung vorgebbar ist.

4. Verfahren nach einem der vorangegangenen Ansprüche,
**dadurch gekennzeichnet, dass**
in einem gebäudeseitigen Heizkreislauf (1) ein Strömungssensor (17) befindlich ist, um einen Heizbedarf zu detektieren, sowie den Betrieb einer Pumpe (12) auszulösen, wodurch das Heizungswasser im Kreislauf zwischen einem Wärmeübertrager (30) und der oder den jeweiligen aktiven Wärmepumpen (3) gefördert wird.

5. Verfahren nach einem der vorangegangenen Ansprüche,
**dadurch gekennzeichnet, dass**
die Wärmepumpen (3) abwechselnd oder rotierend betrieben werden, so dass eine möglichst gleichmäßige Betriebsstundenzahl erreichbar ist.

6. Verfahren nach Anspruch 4 oder 5,
**dadurch gekennzeichnet, dass**
für die Ansteuerung der in dem Heizkreis (1) einspeisender Wärmepumpen (3) im Sommer- oder Übergangsbetrieb diejenigen ausgewählt werden, welche bereits aufgrund der Komponentenkühlung im Betrieb waren oder sind.

7. Verfahren nach einem der vorangegangenen Ansprüche,
**dadurch gekennzeichnet, dass**
für einen Notklimatisierungsbetrieb bei Ausfall der abwärmeerzeugenden Komponenten (9) mindestens eine der Wärmepumpen (3) in einem Betrieb als Luft-Wasser-Wärmepumpe umgeschalten wird.

8. Verfahren nach einem der vorangegangenen Ansprüche,
**dadurch gekennzeichnet, dass**
die Wärmepumpen (3) mit einem außenseitig der Umhausung (20) befindlichen Rückkühler (4) in Verbindung stehen.

9. Verfahren nach einem der vorangegangenen Ansprüche,
**dadurch gekennzeichnet, dass**
zur Übertragung von Wärmeenergie aus dem zweiten Kühlwasserkreislauf mit Luft-Wärmetauscher in den ersten Kühlwasserkreislauf ein Bypass ausgebildet ist.

10. Verfahren nach Anspruch 8,
**dadurch gekennzeichnet, dass**
über ein Dreiwegeventil (6) eine unmittelbare Verbindung des ersten oder zweiten Kühlwasserkreislaufes mit dem Rückkühler (4) zum Freikühlbetrieb herstellbar ist.

11. Verfahren nach Anspruch 7 und 8,
**dadurch gekennzeichnet, dass**
über ein Dreiwegeventil (7) eine Abkopplung von den Komponenten (9) erfolgt und mittels des Dreiwegeventils (6) eine Verbindung zum Rückkühler (4) herstellbar ist, um Wärmeenergie aus der Umgebung zu gewinnen.

12. Anwendung eines Verfahrens nach mindestens einem der vorangegangenen Ansprüche zur Kühlung und Klimatisierung eines Container-basierten Rechenzentrums und angeschlossener, zu beheizender Räumlichkeit für Administrations- und Betriebspersonal, wobei die Kühlung der Rechner über kaltwassergespeiste Wärmetauscher an oder in den Rechnergehäusen zur Kühlung erwärmter Luft sowie unmittelbarer Warmwasserkühlung von leistungsstarken Rechnerkomponenten erfolgt.
